# EUROPEAN PATENT SPECIFICATION

(11) **EP 3 457 493 B1**
(45) Date of publication and mention of the grant of the patent: **29.12.2021**
(21) Application number: 18194125.3
(22) Date of filing: 12.09.2018
(51) Int. Cl.: H01Q 1/08, H01Q 1/22, H01Q 1/38, H01Q 1/52, H01Q 9/04, H01Q 21/06, H01Q 21/08

(54) **ELECTRONIC DEVICE INCLUDING PRINTED CIRCUIT BOARD**
ELEKTRONISCHE VORRICHTUNG MIT LEITERPLATTE
DISPOSITIF ÉLECTRONIQUE COMPRENANT UNE CARTE DE CIRCUIT IMPRIMÉ

(30) Priority: 14.09.2017 KR 20170117584
(43) Date of publication of application: 20.03.2019
(73) Proprietor: Samsung Electronics Co., Ltd., Suwon-si, Gyeonggi-do 16677 (KR)
(72) Inventor: JEON, Seung Gil, 16456 Gyeonggi-do, (KR); KIM, Hyung Wook, 16707 Gyeonggi-do, (KR); LEE, Jeong Heum, 16228 Gyeonggi-do, (KR); LEE, Jong Hwan, 16699 Gyeonggi-do, (KR); IM, Ho Young, 05503 Seoul, (KR)
(74) Representative: HGF

(56) References cited:
- JP-A- H02 252 304
- US-A- 3 895 435
- US-A1- 2004 090 369
- US-A1- 2004 217 830
- US-A1- 2013 002 491
- US-A1- 2013 127 682
- US-B1- 9 755 306
- BEER S ET AL: "Microstrip slot antenna array in LTCC technology for a 122 GHz system-in-package", ANTENNAS AND PROPAGATION SOCIETY INTERNATIONAL SYMPOSIUM (APSURSI), 2012 IEEE, IEEE, 8 July 2012 (2012-07-08), pages 1-2, XP032471577, DOI: 10.1109/APS.2012.6348557 ISBN: 978-1-4673-0461-0

## Description

### BACKGROUND

### 1. Field

The disclosure relates to a technology related to a printed circuit board (PCB) on which an antenna is mounted.

### 2. Description of Related Art

Recently, as the number of smart phone users has increased, an amount of using wireless Internet has also been rapidly increased. In addition to the above-mentioned smart phones, amounts of using tablet personal computers (PCs) and laptops have also been increased, and thus, the use of wireless Internet has been increased in homes as well as offices.

In order to use such wireless Internet by many people, the spread of electronic devices such as a router has increased in offices and homes. For example, the electronic device may be connected to a signal line that is brought into an office or home. The electronic device connected to the signal line may be wirelessly coupled to other electronic devices (e.g., smart phones, tablet PCs, notebooks, and the like). The electronic device may set an Internet protocol (IP) address through the signal line, and transmit/receive various data to/from other electronic devices.

Stacked patch antennas are known from JP H02 252304 A, US 2004/090369 A1 and US 2013/127682 A1. Vertical interconnects are known from US 2004/217830 A1 and US 3 895 435 A.

### SUMMARY

Aspects of the disclosure are to address at least the above-mentioned problems and/or disadvantages and to provide at least the advantages described below. Accordingly, an aspect of the disclosure is to provide a method of forming a director and a spacer on a printed circuit board (PCB) and an electronic device including the PCB.

To increase the signal transmission/reception rate of an electronic device, an electronic device may be equipped with a director and a spacer. The director may induce the signal radiated from an antenna in a specific direction to increase the signal transmission/reception rate of the electronic device. The spacer may increase the signal transmission/reception rate by providing a space into which a dielectric material is introduced between the director and the antenna.

However, when the director and spacer are mounted in an electronic device, respectively, mismatches may occur between the director and the antenna and between the spacer and the antenna. Such a mismatch may reduce the signal transmission/reception rate of the electronic device. In addition, when the director and spacer are mounted in an electronic device, respectively, the production cost may increase and the process may be complicated.

Additional aspects will be set forth in part in the description which follows and, in part, will be apparent from the description, or may be learned by practice of the presented embodiments.

In accordance with an aspect of the disclosure, an electronic device is provided in accordance with claim 1.

According to various embodiments of the disclosure, the performance of an antenna may be improved.

According to various embodiments of the disclosure, the process of manufacturing a PCB and an antenna may be simplified.

According to various embodiments of the disclosure, the manufacturing cost of a PCB and an antenna may be reduced.

In addition, various effects that are directly or indirectly understood through the disclosure may be provided.

Other aspects, advantages, and salient features of the disclosure will become apparent to those skilled in the art from the following detailed description, which, taken in conjunction with the annexed drawings, discloses various embodiments of the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a perspective view illustrating an electronic device according to an embodiment of the disclosure;
FIG. 2 is a perspective view illustrating a printed circuit board (PCB) according to an embodiment of the disclosure;
FIG. 3 is a sectional view illustrating a PCB according to an embodiment of the disclosure;
FIG. 4 is a view illustrating a part of a PCB according to an embodiment of the disclosure;
FIG. 5A is a view illustrating a gain of an electronic device according to an embodiment of the disclosure;
FIG. 5B is a view illustrating a gain of an electronic device according to an embodiment of the disclosure;
FIG. 6A is a perspective view illustrating a PCB according to an embodiment of the disclosure;
FIG. 6B is a view illustrating an isolation of an electronic device according to an embodiment of the disclosure;
FIG. 6C is a view illustrating an antenna unit according to an embodiment of the disclosure;
FIG. 6D is a view illustrating an antenna unit according to an embodiment of the disclosure;
FIG. 6E is a view illustrating a reflection coefficient of an electronic device according to an embodiment of the disclosure;
FIG. 6F is a view illustrating a reflection coefficient of an electronic device according to an embodiment of the disclosure;
FIG. 6G is a view illustrating a reflection coefficient of an electronic device according to an embodiment of the disclosure;
FIG. 7A is a perspective view illustrating a PCB according to an embodiment of the disclosure;
FIG. 7B is a view illustrating an isolation of an electronic device according to an embodiment of the disclosure; and
FIG. 8 is a block diagram of an electronic device in a network environment according to an embodiment of the disclosure.

Throughout the drawings, it should be noted that like reference numbers are used to depict the same or similar elements, features, and structures.

### DETAILED DESCRIPTION

The following description with reference to the accompanying drawings is provided to assist in a comprehensive understanding of various embodiments of the disclosure as defined by the appended claims. It includes various specific details to assist in that understanding but these are to be regarded as merely exemplary. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims.

It is to be understood that the singular forms "a," "an," and "the" include plural referents unless the context clearly dictates otherwise. Thus, for example, reference to "a component surface" includes reference to one or more of such surfaces.

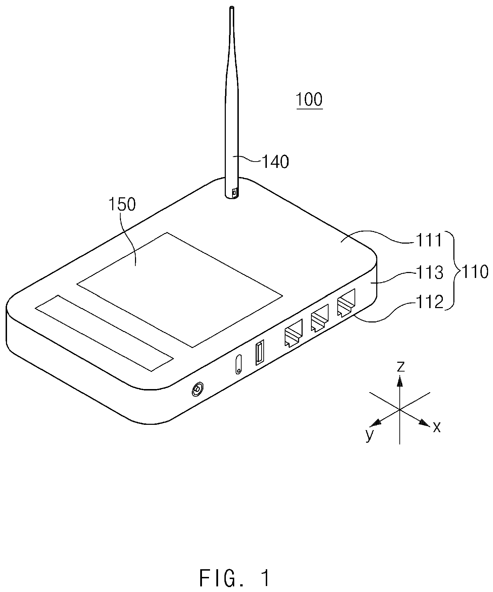

FIG. 1 is a perspective view illustrating an electronic device according to an embodiment of the disclosure.

Referring to FIG. 1, an electronic device 100 may include a housing 110, and first and second antennas 150 and 140.

The housing 110 may form an appearance of the electronic device 100. For example, the housing 110 may include a first surface 111, a second surface 112 facing the first surface 111, and a side surface 113 surrounding between the first and second surfaces 111 and 112. For example, the first surface 111 may form an outer appearance in direction 'z' of the electronic device 100 and the second surface 112 may form an outer appearance in direction '-z' of the electronic device 100. The side surface 113 may form outer appearances in directions, 'x', '-x', 'y' and '-y' of the electronic device 100.

According to an embodiment, the housing 110 may protect various kinds of components included in the electronic device 100 from external impact. For example, a printed circuit board (PCB), a converter, and the like may be included in the electronic device 100, and the housing 110 may protect the components from external impact.

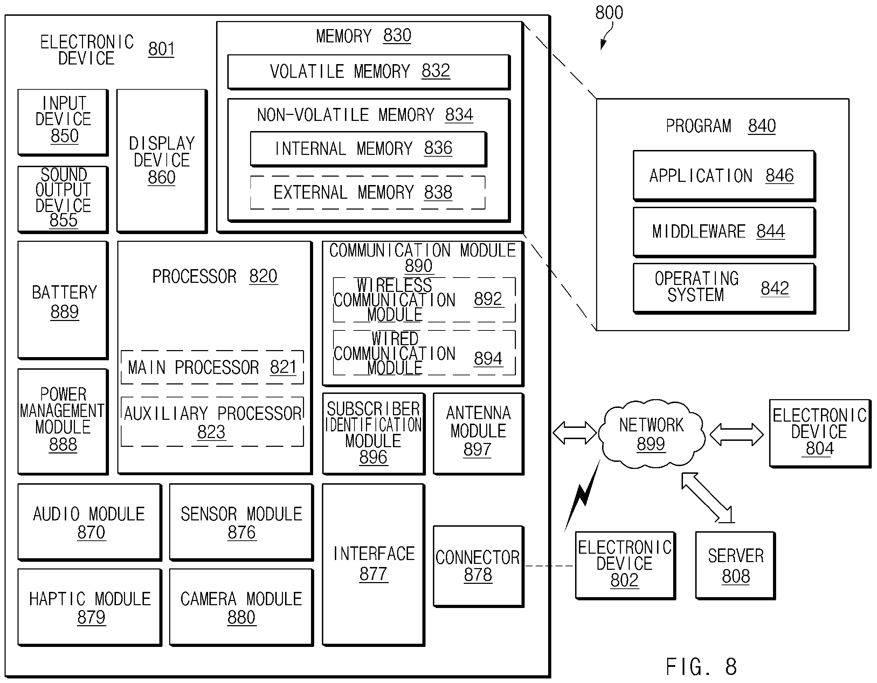

The electronic device 100 may communicate with an external device. For example, the electronic device 100 may receive a signal from a user terminal (e.g., an electronic device 801 of FIG. 8) and transmit the signal to a network. As another example, the electronic device 100 may transmit the signal received from the network to the user terminal. In the disclosure, the electronic device 100 may be referred to as an access point (AP) or a router.

According to an embodiment, the electronic device 100 may transmit/receive a signal through the first antenna 150 to/from a base station. For example, the first antenna 150 may include a spacer attached to the first surface 111 to transmit/receive a signal at a high rate to/from the base station.

According to an embodiment, the electronic device 100 may convert data received through the first antenna 150 into a Wi-Fi or local area network (LAN) signal. The Wi-Fi or LAN signal may be transmitted through the second antenna 140 to another electronic device in a house or building in which the electronic device 100 is installed. Locations and shapes of the first and second antennas 150 and 140 are not limited to those illustrated in FIG. 1, and the electronic device 100 may include another type of an internal antenna.

According to an embodiment, the electronic device 100 may transmit/receive a signal in a specified frequency band. For example, the electronic device 100 may transmit or receive a signal in about 28 GHz band in direction 'z'.

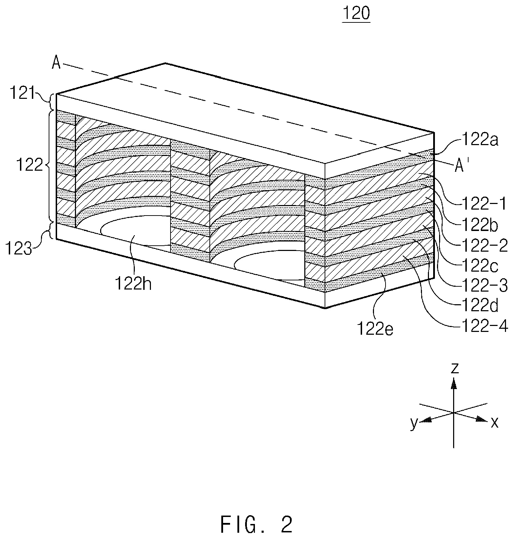

FIG. 2 is a perspective view illustrating a PCB according to an embodiment of the disclosure.

A PCB 120 illustrated in FIG. 2 may be included in the electronic device 100 illustrated in FIG. For example, the PCB 120 may be arranged in the housing 110 illustrated in FIG. 1. The PCB 120 may be arranged between the first and second surfaces 111 and 112.

Referring to FIG. 2, the PCB 120 may include a second substrate 121, a first substrate 123 and a spacer 122. The second substrate 121 may be parallel with the first substrate 123. The first and second substrates 123 and 121 may be formed of a non-conductive material (e.g., plastic). As another example, the first and second substrates 123 and 121 may include a plurality of non-conductive layers and a plurality of conductive layers. The spacer 122 may be arranged between the first and second substrates 123 and 121 and be formed in a portion thereof with an opening 122h. In the disclosure, the first and second substrates 123 and 121 may be referred to as first and second layers, respectively, or first and second regions, respectively. In the disclosure, spacer 122 may be referred to as a side member.

According to an embodiment, the spacer 122 may include a plurality of layers 122a to 122e and 122-1 to 122-4. For example, the spacer 122 may include a plurality of conductive layers 122a to 122e and a plurality of non-conductive layers 122-1 to 122-4. According to an embodiment, the conductive layers 122a to 122e and the non-conductive layers 122-1 to 122-4 may be alternately stacked. For example, a first non-conductive layer 122-1 may be interposed between first and second conductive layers 122a and 122b, and a second non-conductive layer 122-2 may be interposed between the second conductive layer 122b and a third conductive layer 122c. According to an embodiment, the non-conductive layers 122-1 to 122-4 may be formed of a non-conductive material (e.g., plastic). The conductive layers 122a to 122e may be formed of a conductive material (e.g., copper (Cu)).

According to an embodiment, adhesive material may be interposed between the second substrate 121 and the spacer 122 and between the spacer 122 and the first substrate 123. For example, the adhesive materials may allow the second substrate 121 and the spacer 122 to adhere to each other and allow the spacer 122 and the first substrate 123 to adhere to each other.

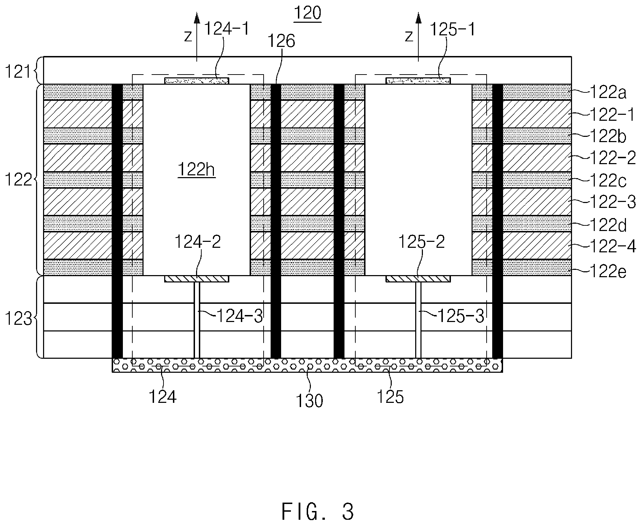

FIG. 3 is a sectional view illustrating a PCB according to an embodiment of the disclosure. The sectional view illustrated in FIG. 3 is taken along line A-A' of the PCB 120 illustrated in FIG. 2.

Referring to FIG. 3, the PCB 120 may include at least one antenna unit 124 and 125 and a via 126. Each of the antenna units 124 and 125 may include a director 124-1 or 125-1, a patch-type radiator 124-2 or 125-2, and a feeder 124-3 or 125-3. The communication circuit 130 may be arranged in the PCB 120 or coupled to the PCB 120. Although the communication circuit 130 arranged under the PCB 120 is illustrated in FIG. 3, the location of the communication circuit 130 is not limited thereto. For example, the communication circuit 130 may be arranged on a side surface of the PCB 120 and may be electrically connected to the antenna units 124 and 125 through specified wires (e.g., a flexible printed circuit board). The first and second antenna units 124 and 125 are illustrated in FIG. 3, but the following description will be focused on the first antenna unit 124. In the disclosure, the communication circuit 130 may be referred to as an external part. In the disclosure, director 124-1 or 125-1 may be referred to as a first conductive member. In the disclosure, patch-type radiator 124-2 or 125-2 may be referred to as a second conductive member.

According to an embodiment, the director 124-1 may be formed on the second substrate 121. For example, the director 124-1 may be formed on a surface of the second substrate 121 or inside the second substrate 121. As another example, the second substrate 121 may include a plurality of layers, and the director 124-1 may be arranged on one of the layers. In the disclosure, the director 124-1 may be referred to as an inducer.

According to an embodiment, the patch-type radiator 124-2 may be formed on the first substrate 123. For example, the patch-type radiator 124-2 may be formed on a surface of the first substrate 123 or inside the first substrate 123.

According to an embodiment, the director 124-1 and the patch-type radiator 124-2 may be spaced apart from each other by the spacer 122. For example, since the spacer 122 is interposed between the second substrate 121 and the first substrate 123, the director 124-1 and the patch-type radiator 124-2 may be spaced apart from each other by the spacer 122.

According to an embodiment, the director 124-1 and the patch-type radiator 124-2 face each other through the opening 122h. A dielectric material (e.g., air) may be provided in the opening 122h, where the permittivity of the dielectric material may be a specific value or less.

According to an embodiment, the feeder 124-3 may electrically connect the patch-type radiator 124-2 to the communication circuit 130. For example, when the communication circuit 130 is coupled to the first substrate 123, the feeder 124-3 may pass through the first substrate 123 to connect the patch-type radiator 124-2 to the communication circuit 130.

According to an embodiment, the director 124-1, the patch-type radiator 124-2 and the feeder 124-3 may be formed of a metallic material (e.g., Cu). For example, a current may flow through the director 124-1, the patch-type radiator 124-2 and the feeder 124-3.

According to an embodiment, the communication circuit 130 may feed power to the feeder 124-3. In the disclosure, the term "feeding" may mean an operation of applying a current to the feeder 124-3 by the communication circuit 130. When a current is fed, the communication circuit 130 may transmit/receive a signal in a specified frequency band (e.g., about 28 GHz) based on the electric path formed through the feeder 124-3 and the patch-type radiator 124-2.

According to an embodiment, the director 124-1 may induce the signal, which the communication circuit 130 transmits/receive, in a specified direction. For example, the director 124-1 may induce the signal such that the signal is radiated in direction 'z' or fed in direction '-z'. Since the signal radiated or fed through the director 124-1 is concentrated, the strength may be enhanced.

According to an embodiment, the via 126 may be provided between the antenna units 124 and 125, such that the electromagnetic interference between the antenna units 124 and 125 may be reduced. For example, the via 126 may reduce the electromagnetic interference between the first and second antenna units 124 and 125. Although the vias 126 provided on both sides of each antenna unit are illustrated in FIG. 3 that is a sectional view of the PCB 120, a plurality of vias may surround the patch-type radiator 124-2 or the opening 122h.

In the disclosure, the contents described in FIGS. 1 to 3 may be applied to the components that have the same reference numeral as the electronic device 100 and the PCB 120 illustrated in FIGS. 1 to 3. In addition, the PCB 120 and the communication circuit 130 illustrated in FIGS. 1 to 3 may include the first antenna 150. In the document, the director 124-1 and the patch-type radiator 124-2 may be referred to as first and second conductive member, respectively.

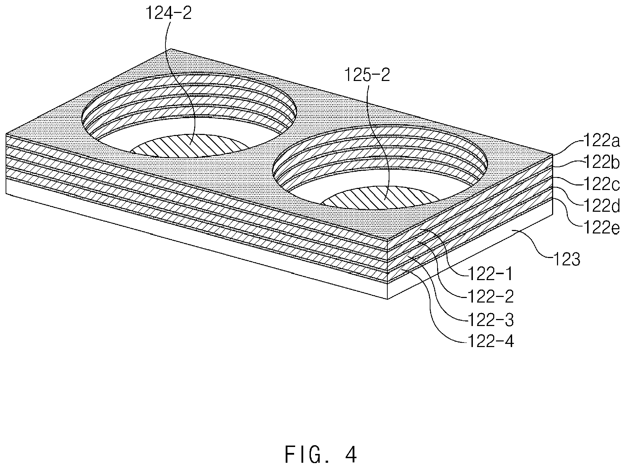

FIG. 4 is a view illustrating a part of a PCB according to an embodiment of the disclosure. FIG. 4 illustrates the PCB 120 from which the second substrate 121 is removed.

Referring to FIG. 4, the non-conductive layers 122-1 to 122-4 and the conductive layers 122a to 122e may be alternately stacked on the first substrate 123. For example, the fifth conductive layer 122e may be stacked on the first substrate 123 and the fourth non-conductive layer 122-4 may be stacked on the fifth conductive layer 122e. The other conductive and non-conductive layers 122a to 122d and 122-1 to 122-3 may be alternately stacked on the fourth non-conductive layer 122-4.

According to an embodiment, the patch-type radiators 124-2 and 125-2 may be mounted on the first substrate 123. For example, the patch-type radiators 124-2 and 125-2 may be arranged on the surface of the first substrate 123 or inside the first substrate 123, such that the patch-type radiators 124-2 and 125-2 at least partially overlap the opening 122h formed in the PCB when viewed from above the second substrate 121. The patch-type radiators 124-2 and 125-2 may transmit/receive a signal through a hole formed between the non-conductive and conductive layers 122-1 to 122-4 and 122a to 122e.

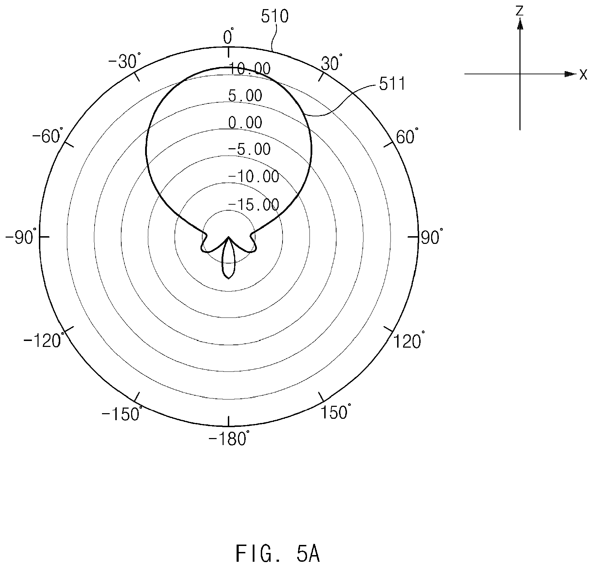

FIG. 5A is a view illustrating a gain of an electronic device according to an embodiment of the disclosure.

Referring to FIG. 5A, the electronic device according to a comparative example may mean an electronic device that does not include the PCB 120 illustrated in FIG. 2.

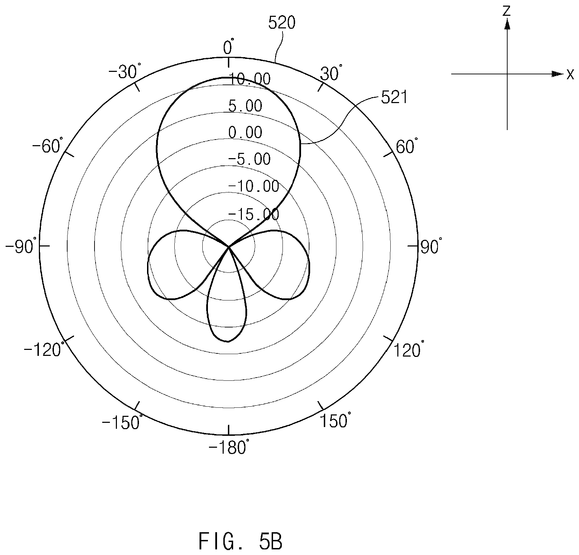

FIG. 5B is a view illustrating a gain of an electronic device according to an embodiment of the disclosure.

Referring to FIG. 5B, the gain of the electronic device 100 illustrated in FIG. 1.

The planes 510 and 520 illustrated in FIGS. 5A and 5B may mean x-z or y-z planes when it is assumed that the electronic device according to the comparative example and the electronic device 100 are located at the center of a rectangular coordinate system, respectively. For example, when the planes 510 and 520 illustrated in FIGS. 5A and 5B are x-z planes, 0° may mean the direction 'z', -180° may mean the direction '-z', 90° may mean the direction 'x', and -90° may mean the direction '-x'. Hereinafter, it will be assumed that the planes 510 and 520 are x-z planes.

Referring to a graph 511, the electronic device according to the comparative example may have a gain of about 10 dB in the z direction. However, the electronic device according to the comparative example may have a very small gain in the -z, x and -x directions. For example, the electronic device according to the comparative example may radiate a signal having a strong intensity in the z direction, but may radiate only a signal having a very weak intensity in the -z, x and -x directions.

Referring to a graph 521, the electronic device 100 according to an embodiment may have a gain of about 10 dB in the z direction. The electronic device 100 according to an embodiment may have a gain of about -5 dB in the -z, x, and -x directions. In other words, the electronic device 100 according to an embodiment of the disclosure may radiate a stronger signal in the -z, x and -x directions than the electronic device according to the comparative example.

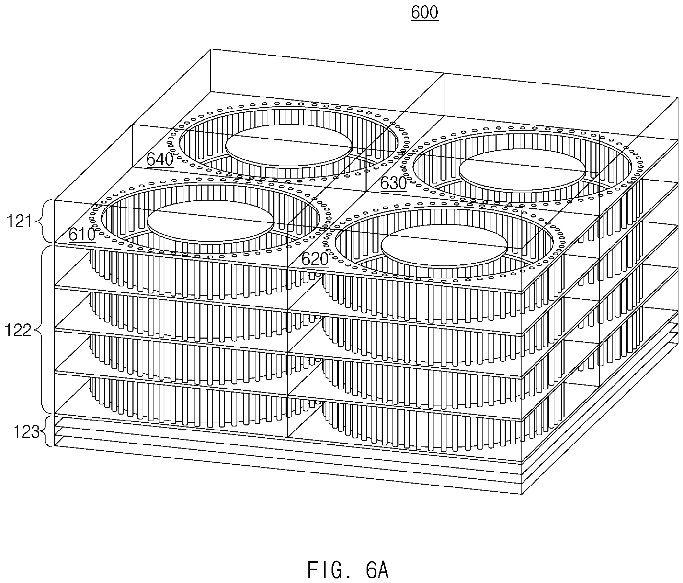

FIG. 6A is a perspective view illustrating a PCB according to an embodiment of the disclosure.

Referring to FIG. 6A, a PCB 600 may be included in the electronic device 100 illustrated in FIG. 1. For example, the PCB 600 may be arranged inside the housing 110 illustrated in FIG. 1. The PCB 600 may be arranged between the first and second surfaces 111 and 112.

The PCB 120 illustrated in FIG. 2 may be substantially the same as or similar to the PCB 600 illustrated in FIG. 6A except for the number of mounted antenna units. First to fourth antenna units 610 to 640 may be substantially the same as or similar to the first antenna unit 124 illustrated in FIG. 3. For example, the first to fourth antenna units 610 to 640 may include the director 124-1, the patch-type radiator 124-2, and the feeder 124-3. As another example, the director 124-1 and the patch-type radiator 124-2 may be spaced apart from each other by the spacer 122.

Although not illustrated in FIG. 6A, according to an embodiment, the communication circuit 130 may be arranged under the PCB 600. The communication circuit 130 may feed power to the first to fourth antenna units 610 to 640. The communication circuit 130 may radiate a signal in a specified frequency band based on the electric path formed through the first to fourth antenna units 610 to 640.

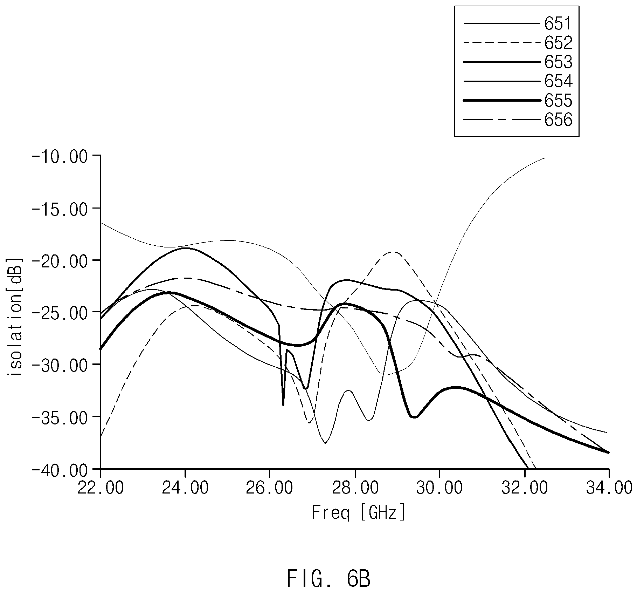

FIG. 6B is a view illustrating an isolation of an electronic device according to an embodiment of the disclosure.

Referring to FIG. 6B, graphs 651 to 656 illustrate isolations between the antenna units 610 to 640 illustrated in FIG. 6A. For example, the graph 651 illustrates the isolation between the first and second antenna units 610 and 620, and the graph 652 illustrates the isolation between the first and third antenna units 610 and 630. The graph 653 illustrates the isolation between the first and fourth antenna units 610 and 640, and the graph 654 illustrates the isolation between the second and third antenna units 620 and 630. The graph 655 illustrates the isolation between the second and fourth antenna units 620 and 640, and the graph 656 illustrates the isolation between the third and fourth antenna units 630 and 640.

Referring to the graphs 651 to 656, it may be confirmed that the isolations of the graphs 651 to 656 are good in a specified frequency band (e.g., 28 GHz). For example, in the case of the graph 651, it may be confirmed that the isolation in the 28 GHz band is better than the isolation in 32 GHz or above. In the case of the graph 653, the isolation in the 28 GHz band is better than that in 24 GHz band. For example, in all the graphs 651 to 656, in common, very good isolations (e.g., 15 dB or less) may be given in 28 GHz band. For example, the electronic device 100 may radiate a signal in 28 GHz band in which the isolation is best.

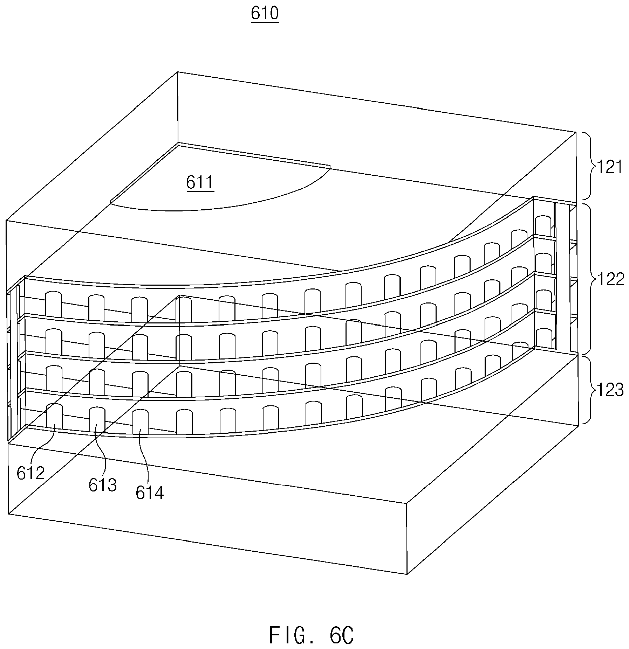

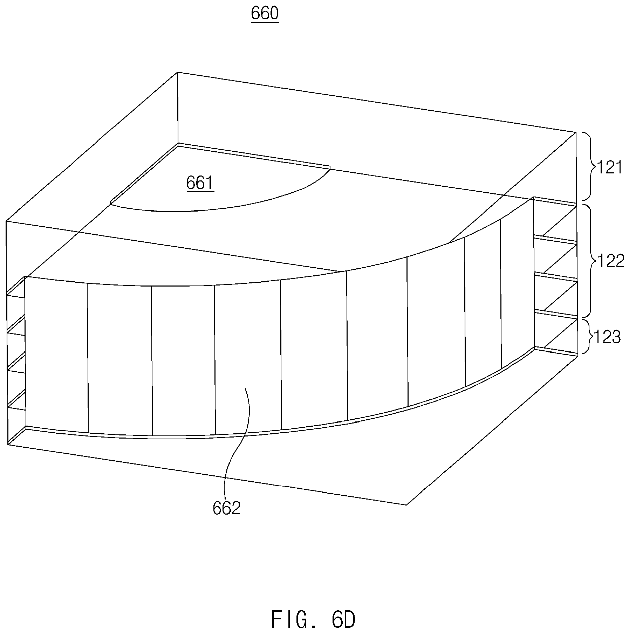

FIG. 6C is a view illustrating an antenna unit according to an embodiment of the disclosure. FIG. 6D is a view illustrating an antenna unit according to an embodiment of the disclosure. The antenna unit 610 illustrated in FIG. 6C and the antenna unit 660 illustrated in FIG. 6D may be included in the PCB 600 illustrated in FIG. 6A.

Referring to FIG. 6C, the antenna unit 610 may include the second substrate 121, the first substrate 123 and the spacer 122. According to an embodiment, a director 611 may be formed in the second substrate 121. Although not illustrated, a patch-type radiator may be formed in the first substrate 123.

According to an embodiment, the director 611 and the patch-type radiator may face each other through an inner space of the spacer 122. A plurality of vias 612 to 614 may surround the inner space. When a signal is transmitted/received through the antenna unit 610, the vias 612 to 614 may reduce the electromagnetic interference with another antenna unit (e.g., 620 of FIG. 6A).

Referring FIG. 6D, the antenna unit 660 may be arranged on the second substrate 121, the first substrate 123 and the spacer 122. For example, a director 661 may be formed on the second substrate 121. Although not illustrated, the patch-type radiator may be formed on the first substrate 123.

According to an embodiment, the director 661 and the patch-type radiator may face each other through the inner space of the spacer 122. According to an embodiment, a circumference of at least one inner space included in the spacer 122 may be surrounded by a via hole or a conductive material. When a signal is transmitted/received through the antenna unit 660, a side surface of the spacer 122 may reduce the electromagnetic interference with another antenna unit. According to an embodiment, a side surface 662 of the spacer 122 may be plated or surrounded by a conductive material (e.g., aluminum (Al) or Cu).

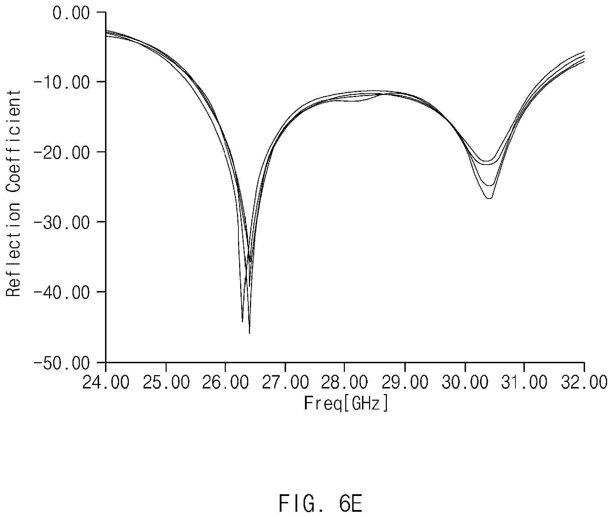

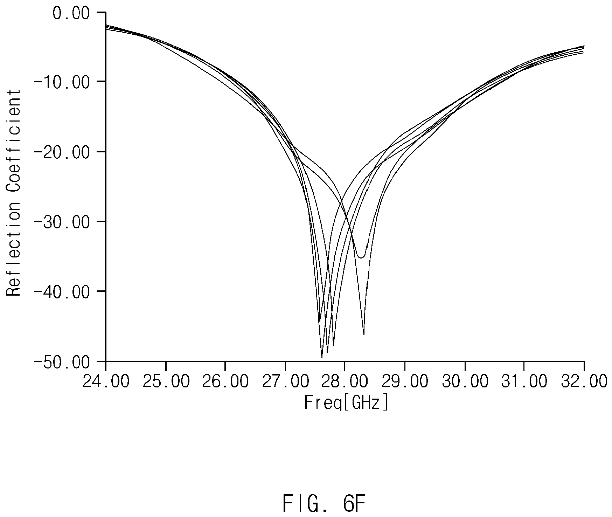

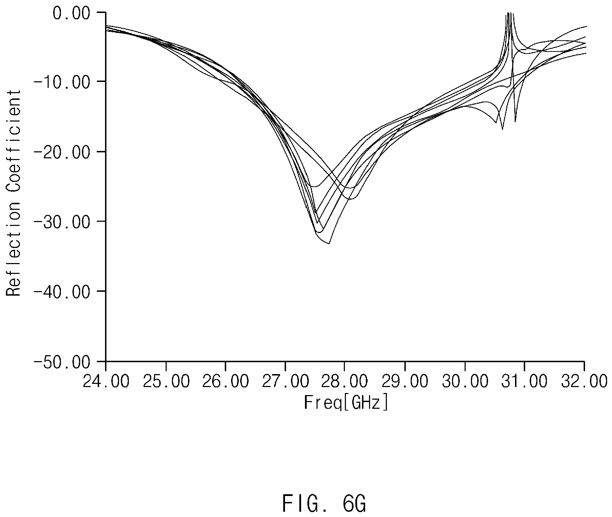

FIG. 6E is a view illustrating reflection coefficients of antenna units included in an electronic device according to an embodiment of the disclosure. FIG. 6F is a view illustrating reflection coefficients of antenna units included in an electronic device according to an embodiment of the disclosure. FIG. 6G is a view illustrating reflection coefficients of antenna units included in an electronic device according to an embodiment of the disclosure.

Referring to FIG. 6E, the graphs illustrated represent a reflection coefficient of an electronic device including an antenna unit (e.g., the antenna unit 660 including the spacer 122 plated by Al of FIG. 6D). Referring to FIG. 6F, the graphs illustrated represent a reflection coefficient of an electronic device including the antenna unit 610. Referring to FIG. 6G, the graphs illustrated represent a reflection coefficient of an electronic device including an antenna unit (e.g., the antenna unit 660 including the spacer 122 plated by Cu of FIG. 6D).

**Table 1**

| Performance comparison | Scheme of implementing side surface of spacer 122 | | | Remarks |
|---|---|---|---|---|
| | Aluminum | Via | Copper | |
| Gain[dB] | 16.1 | 15.9 | 15.9 | Main beam |
| HPBW[deg] | 24° | 24° | 24° | Main beam |
| BW[GHz] | 5.8 | 4.1 | 3.8 | S₁₁-10dB |
| Isolation[dB] | -18.5 | -16.5 | -16 | All ports |

Table 1 illustrates a gain, a half power beam width, a bandwidth, and an isolation of an electronic device.

Referring to the graphs illustrated in FIGS. 6E to 6G and the Table 1, when the side surface of the spacer 122 is formed of Al (hereinafter, referred to as a first case), the electronic device may transmit/receive a signal of about 26 GHz band or about 30.5 GHz band. When the side surface of the spacer 122 includes vias (hereinafter, referred to as a second case) and the side surface of the spacer 122 is formed of copper (hereinafter, referred to as a third case), the electronic device may transmit/receive a signal of about 28 GHz band.

According to an embodiment, in all the cases, the gains and the half power beam widths are equal to or similar to each other. For example, in all the first to third cases, the electronic device may transmit/receive signals having the same intensity or similar intensities in a specific direction.

According to an embodiment, since the bandwidth of the first case is 5.8 GHz and the bandwidth of the second case is 4.1 GHz, the bandwidth of the first case may be larger than that of the second case. Since the bandwidth of the second case is 4.1 GHz and the bandwidth of the third case is 3.8 GHz, the bandwidth of the second case may be larger than that of the third case.

According to an embodiment, since the isolation of the first case is -18.5 dB and the isolation of the second case is -16.5 dB, the isolation of the second case may be better than that of the first case. Since the isolation of the second case is -16.5 dB and the isolation of the third case is -16.5 dB, the isolation of the third case may be better than that of the second case.

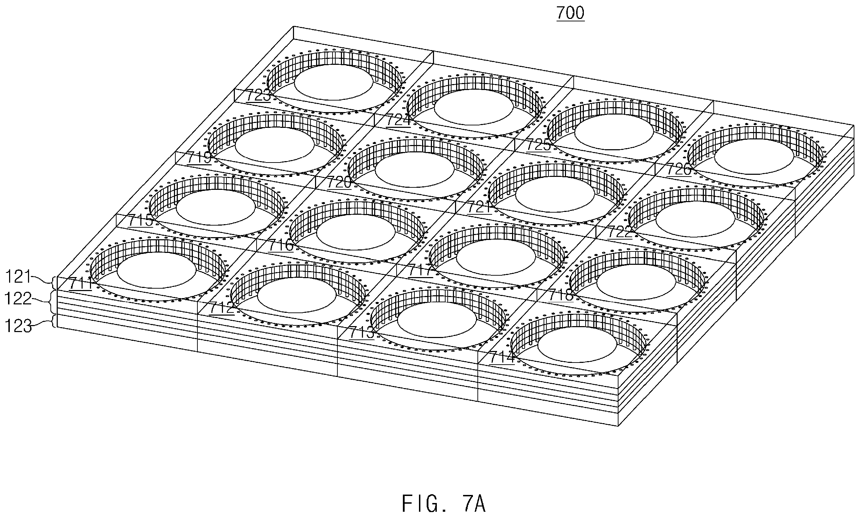

FIG. 7A is a perspective view illustrating a PCB according to an embodiment of the disclosure.

Referring to FIG. 7A, a PCB 700 may be included in the electronic device 100 illustrated in FIG. 1. For example, the PCB 700 may be arranged in the housing 110 illustrated in FIG. 1. The PCB 700 may be arranged between the first and second surfaces 111 and 112.

The PCB 600 illustrated in FIG. 6A may be substantially the same as or similar to the PCB 700 illustrated in FIG. 7A. Each of first to sixteenth antenna units 711 to 726 may be substantially the same as or similar to the first antenna unit 124 illustrated in FIG. 3. For example, each of the first to sixteenth antenna units 711 to 726 may include the director 124-1, the patch-type radiator 124-2, and the feeder 124-3. As still another example, the director 124-1 and the patch-type radiator 124-2 may be spaced apart from each other by the spacer 122.

Although not illustrated in FIG. 7A, according to an embodiment, the communication circuit 130 may be arranged under the PCB 700. The communication circuit 130 may feed power to the first to sixteenth antenna units 711 to 726. The communication circuit 130 may radiate a signal in a specified frequency band based on the electric path formed through the first to sixteenth antenna units 711 to 726. For example, the communication circuit 130 may radiate a signal in a frequency band in which the isolations between the first to sixteenth antenna units 711 to 726 are the best.

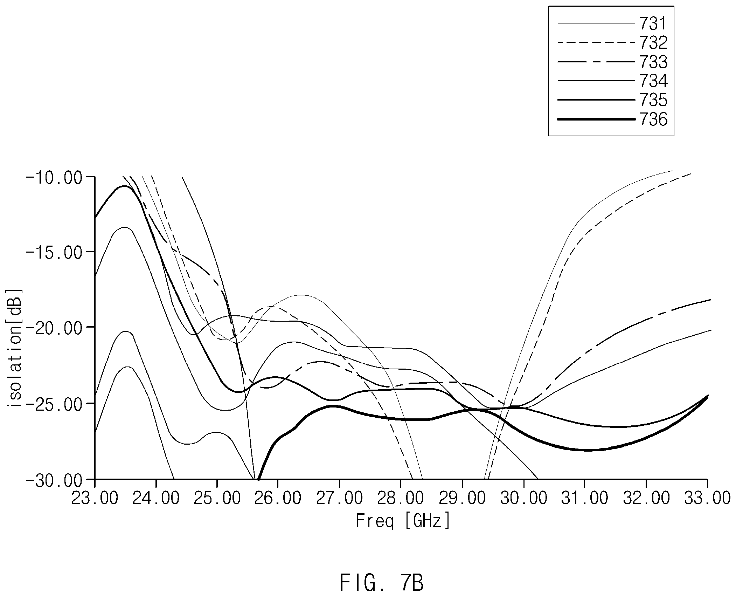

FIG. 7B illustrates an isolation of an electronic device according to an embodiment of the disclosure.

Referring to FIG. 7B, graphs 731 to 736 illustrate isolations between the antenna units 711 to 726 illustrated in FIG. 7A. For example, the graph 731 illustrates the isolation between the first and second antenna units 711 and 712, and the graph 732 illustrates the isolation between the first and third antenna units 711 and 713. The graph 733 illustrates the isolation between the first and fourth antenna units 711 and 714, and the graph 734 illustrates the isolation between the first and fifth antenna units 711 and 715. The graph 735 illustrates the isolation between the first and sixth antenna units 711 and 716, and the graph 736 illustrates the isolation between the first and seventh antenna units 711 and 717. Although a total of 120 graphs may be illustrated in the above-described sequence, the description of the remaining graphs will be omitted for convenience of explanation.

Referring to the graphs 731 to 736, as illustrated in FIG. 6B, it may be confirmed that the isolations of the graphs 731 to 736 are good in a specified frequency band (e.g., 28 GHz). For example, in the case of the graph 731, it may be confirmed that the isolation in the 28 GHz band is better than the isolation in 32 GHz or above. In the case of the graph 733, the isolation in the 28 GHz band is better than that in 24 GHz band. For example, in all the graphs 731 to 736, in common, the isolations of a certain degree or above may be given in 28 GHz band. For example, the electronic device 100 may radiate a signal in 28 GHz band in which the isolation is best.

According to an embodiment of the disclosure, the electronic device 100 may include the housing 110 that includes the first surface 111, the second surface 112 facing the first surface 111, and the side surface 113 surrounding a space between the first and second surfaces 111 and 112, the PCB 120 that is arranged inside the housing 110 and includes at least one antenna unit, and the communication circuit 130 that is arranged inside the PCB 120 or between the PCB 120 and the housing 110, where the PCB 120 includes the first substrate 123, the second substrate 121 facing the first substrate 123, and the spacer 122 arranged between the first and second substrates 121 and 123 and formed on a specified region with the opening 122h, wherein each of the antenna units 124 and 125 includes the director 124-1 and 125-1 formed on the first substrate 123, the patch-type radiator 124-2 and 125-2 formed on the second substrate 121 and facing the director 124-1 and 125-1 through the opening 122h, and the feeder 124-3 and 125-3 connecting the patch-type radiators 124-2 and 125-2 to the communication circuit 130, and wherein the communication circuit 130 feeds power to the feeder 124-3 and 125-3 and transmits/receives a signal of a specified frequency band through an electrical path formed through the feeder 124-3 and 125-3 and the patch-type radiator 124-2 and 125-2.

According to an embodiment of the disclosure, a dielectric material may be provided in a space between the patch-type radiator 124-2 and 125-2 and the director 124-1 and 125-1.

According to an embodiment of the disclosure, each of the antenna units 124 and 125 may further include the plurality of vias 126 surrounding the opening 122h.

According to an embodiment of the disclosure, the at least one antenna unit may include the first and second antenna units 124 and 125, and the plurality of vias 126 may block interference between the first and second antenna units 124 and 125.

According to an embodiment of the disclosure, the first and second antenna units 124 and 125 may transmit/receive signals of mutually different frequency bands.

According to an embodiment of the disclosure, the director 124-1 and 125-1 and the patch-type radiator 124-2 and 125-2 may be formed of a conductive material.

According to an embodiment of the disclosure, there may be formed specified interval distances between the director 124-1 and 125-1 and the spacer 122 and between the spacer 122 and the patch-type radiator 124-2 and 125-2.

According to an embodiment of the disclosure, the first substrate 123 and the spacer 122 may adhere to each other by an adhesive material, and the spacer 122 and the second substrate 121 may adhere to each other by the adhesive material.

According to an embodiment of the disclosure, the spacer 122 may include the plurality of non-conductive layers 122-1 to 122-4 between which the conductive layers 122a to 122e are arranged, respectively.

According to an embodiment of the disclosure, the PCB 120 may be arranged between the patch-type radiator 124-2 and 125-2 and the spacer 122, and may further include a non-conductive material surrounding the patch-type radiator 124-2 and 125-2.

According to an embodiment of the disclosure, the PCB 120 may include the first layer 123, the second layer 121 facing the first layer 123, the side member 122 arranged between the first and second layers 123 and 121 and formed in a specified region with the opening 122h, the first conductive member 124-1 and 125-1 formed on the second layer 121, the second conductive member 124-2 and 125-2 formed on the first layer 123 and facing the first conductive member 124-1 and 125-1 through the opening 122h, and the feeder 124-3 and 125-3 connecting the second conductive member 124-2 and 125-2 to the external component 130.

According to an embodiment of the disclosure, the first and second layers 123 and 121 may be formed of a non-conductive material.

According to an embodiment of the disclosure, the PCB 120 may further include the plurality of vias 126 surrounding the opening 122h, and the vias 126 may extend from the first layer 123 to the second layer 121.

According to an embodiment of the disclosure, the first layer 123 and the side member 122 may adhere to each other by an adhesive material, and the side member 122 and the second layer 121 may adhere to each other by the adhesive material.

According to an embodiment of the disclosure, the side member 122 may include the plurality of non-conductive layers 122-1 to 122-4, and the conductive layers 122a to 122e may be arranged between the non-conductive layers 122-1 to 122-4, respectively.

According to an embodiment of the disclosure, specified interval distances may be formed between the first conductive member 124-1 and 125-1 and the side member 122 and between the second conductive member 124-2 and 125-2 and the side member 122.

According to an embodiment of the disclosure, the electronic device 100 may include the housing 110 that includes the first surface 111, the second surface 112 facing the first surface 111, and the side surface 113 surrounding a space between the first and second surfaces 111 and 112, and the PCB 120 that is arranged inside the housing 110 or is attached to the first surface 111, wherein the PCB 120 includes the at least one antenna unit 124 and 125 and the wireless communication circuit 130 electrically connected to each of the at least one antenna unit 124 and 125, wherein each of the antenna units includes the director 124-1 and 125-1 arranged in the second region 121, the patch-type radiator 124-2 and 125-2 arranged in the first region 123 facing the second region 121, and the feeder 124-3 and 125-3 electrically connecting the patch-type radiator 124-2 and 125-2 to the wireless communication circuit 130, and wherein the wireless communication circuit 130 feeds power to the feeder 124-3 and 125-3 and transmits/receives a signal of a specified frequency band through an electrical path formed through the feeder 124-3 and 125-3 and the patch-type radiator 124-2 and 125-2.

According to an embodiment of the disclosure, the PCB 120 may further include the spacer 122 that spaces the first and second regions 123 and 121 apart from each other, and the director 124-1 and 125-1 and the patch-type radiator 124-2 and 125-2 may face each other through the opening 122h formed in the spacer 122.

According to an embodiment of the disclosure, each of the antenna units 124 and 125 may further include the plurality of vias 126 surrounding the opening 122h.

According to an embodiment of the disclosure, the PCB 120 may include the first substrate 123 and the second substrate 121 facing the first substrate 123, wherein the spacer 122 is arranged between the first and second substrates 123 and 121, wherein the first region 123 includes at least a part of the first substrate 123, and wherein the second region 121 includes at least a part of the second substrate 121.

According to an embodiment of the disclosure, the electronic device 100 may include the housing 110, an antenna structure that includes the first substrate 123 including a plurality of conductive regions, the second substrate 121 formed of an insulating material, and the first plurality of insulating layers 122-1 to 122-4 and the second plurality of conductive layers 122a to 122e that are alternately stacked between the first and second substrates 123 and 121, wherein the first plurality of insulating layers 122-1 to 122-4 and the second plurality of conductive layers 122a to 122e form a plurality of inner spaces between the first and second substrates 123 and 121 such that the conductive regions are exposed to the inner spaces and located in the inner spaces when viewed from above the first substrate 123, and the wireless communication circuit 130 electrically connected to the conductive regions.

According to an embodiment of the disclosure, the wireless communication circuit 130 may be configured to transmit and/or receive a signal of a frequency band of 26 GHz to 31 GHz.

According to an embodiment of the disclosure, the second substrate 121 may be thicker than at least one of the first plurality of insulating layers 122-1 to 122-4.

According to an embodiment of the disclosure, the first plurality of insulating layers 122-1 to 122-4 may be formed through the insulating layers between two of the second plurality of conductive layers 122a to 122e and may include the plurality of vias 126 surrounding the inner spaces in the side surface 113.

FIG. 8 is a block diagram of an electronic device in a network environment according to an embodiment of the disclosure.

Referring to FIG. 8, an electronic device 801 may communicate with an electronic device 802 through a first network (e.g., a short-range wireless communication) or may communicate with an electronic device 804 or a server 808 through a second network 899 (e.g., a long-distance wireless communication) in a network environment 800. According to an embodiment, the electronic device 801 may communicate with the electronic device 804 through the server 808. According to an embodiment, the electronic device 801 may include a processor 820, a memory 830, an input device 850, a sound output device 855, a display device 860, an audio module 870, a sensor module 876, an interface 877, a haptic module 879, a camera module 880, a power management module 888, a battery 889, a communication module 890, a subscriber identification module 896, and an antenna module 897. According to various embodiments, at least one (e.g., the display device 860 or the camera module 880) among components of the electronic device 801 may be omitted or other components may be added to the electronic device 801. According to various embodiments, some components may be integrated and implemented as in the case of the sensor module 876 (e.g., a fingerprint sensor, an iris sensor, or an illuminance sensor) embedded in the display device 860 (e.g., a display).

The processor 820 may operate, for example, software (e.g., a program 840) to control at least one of other components (e.g., a hardware or software component) of the electronic device 801 connected to the processor 820 and may process and compute a variety of data. The processor 820 may load a command set or data, which is received from other components (e.g., the sensor module 876 or the communication module 890), into a volatile memory 832, may process the loaded command or data, and may store result data into a nonvolatile memory 834. According to an embodiment, the processor 820 may include a main processor 821 (e.g., a central processing unit or an application processor) and an auxiliary processor 823 (e.g., a graphic processing device, an image signal processor, a sensor hub processor, or a communication processor), which operates independently from the main processor 821, additionally or alternatively uses less power than the main processor 821, or is specified to a designated function. In this case, the auxiliary processor 823 may operate separately from the main processor 821 or embedded.

In this case, the auxiliary processor 823 may control, for example, at least some of functions or states associated with at least one component (e.g., the display device 860, the sensor module 876, or the communication module 890) among the components of the electronic device 801 instead of the main processor 821 while the main processor 821 is in an inactive (e.g., sleep) state or together with the main processor 821 while the main processor 821 is in an active (e.g., an application execution) state. According to an embodiment, the auxiliary processor 823 (e.g., the image signal processor or the communication processor) may be implemented as a part of another component (e.g., the camera module 880 or the communication module 890) that is functionally related to the auxiliary processor 823. The memory 830 may store a variety of data used by at least one component (e.g., the processor 820 or the sensor module 876) of the electronic device 801, for example, software (e.g., the program 840) and input data or output data with respect to commands associated with the software. The memory 830 may include the volatile memory 832 or the nonvolatile memory 834.

The program 840 may be stored in the memory 830 as software and may include, for example, an operating system 842, a middleware 844, or an application 846.

The input device 850 may be a device for receiving a command or data, which is used for a component (e.g., the processor 820) of the electronic device 801, from an outside (e.g., a user) of the electronic device 801 and may include, for example, a microphone, a mouse, or a keyboard.

The sound output device 855 may be a device for outputting a sound signal to the outside of the electronic device 801 and may include, for example, a speaker used for general purposes, such as multimedia play or recordings play, and a receiver used only for receiving calls. According to an embodiment, the receiver and the speaker may be either integrally or separately implemented.

The display device 860 may be a device for visually presenting information to the user and may include, for example, a display, a hologram device, or a projector and a control circuit for controlling a corresponding device. According to an embodiment, the display device 860 may include a touch circuitry or a pressure sensor for measuring an intensity of pressure on the touch.

The audio module 870 may convert a sound and an electrical signal in dual directions. According to an embodiment, the audio module 870 may obtain the sound through the input device 850 or may output the sound through an external electronic device (e.g., the electronic device 802 (e.g., a speaker or a headphone)) wired or wirelessly connected to the sound output device 855 or the electronic device 801.

The sensor module 876 may generate an electrical signal or a data value corresponding to an operating state (e.g., power or temperature) inside or an environmental state outside the electronic device 801. The sensor module 876 may include, for example, a gesture sensor, a gyro sensor, a barometric pressure sensor, a magnetic sensor, an acceleration sensor, a grip sensor, a proximity sensor, a color sensor, an infrared sensor, a biometric sensor, a temperature sensor, a humidity sensor, or an illuminance sensor.

The interface 877 may support a designated protocol wired or wirelessly connected to the external electronic device (e.g., the electronic device 802). According to an embodiment, the interface 877 may include, for example, an high-definition multimedia interface (HDMI), a universal serial bus (USB) interface, a secure digital (SD) card interface, or an audio interface.

A connection terminal 878 may include a connector that physically connects the electronic device 801 to the external electronic device (e.g., the electronic device 802), for example, an HDMI connector, a USB connector, an SD card connector, or an audio connector (e.g., a headphone connector).

The haptic module 879 may convert an electrical signal to a mechanical stimulation (e.g., vibration or movement) or an electrical stimulation perceived by the user through tactile or kinesthetic sensations. The haptic module 879 may include, for example, a motor, a piezoelectric element, or an electric stimulator.

The camera module 880 may shoot a still image or a video image. According to an embodiment, the camera module 880 may include, for example, at least one lens, an image sensor, an image signal processor, or a flash.

The power management module 888 may be a module for managing power supplied to the electronic device 801 and may serve as at least a part of a power management integrated circuit (PMIC).

The battery 889 may be a device for supplying power to at least one component of the electronic device 801 and may include, for example, a non-rechargeable (primary) battery, a rechargeable (secondary) battery, or a fuel cell.

The communication module 890 may establish a wired or wireless communication channel between the electronic device 801 and the external electronic device (e.g., the electronic device 802, the electronic device 804, or the server 808) and support communication execution through the established communication channel. The communication module 890 may include at least one communication processor operating independently from the processor 820 (e.g., the application processor) and supporting the wired communication or the wireless communication. According to an embodiment, the communication module 890 may include a wireless communication module 892 (e.g., a cellular communication module, a short-range wireless communication module, or a global navigation satellite system (GNSS) communication module) or a wired communication module 894 (e.g., a LAN communication module or a power line communication module) and may communicate with the external electronic device using a corresponding communication module among them through the first network (e.g., the short-range communication network such as a Bluetooth, a WiFi direct, or an infrared data association (IrDA)) or the second network 899 (e.g., the long-distance wireless communication network such as a cellular network, an internet, or a computer network (e.g., LAN or wide area network (WAN)). The above-mentioned various communication modules 890 may be implemented into one chip or into separate chips, respectively.

According to an embodiment, the wireless communication module 892 may identify and authenticate the electronic device 801 using user information stored in the subscriber identification module 896 in the communication network.

The antenna module 897 may include one or more antennas to transmit or receive the signal or power to or from an external source. According to an embodiment, the communication module 890 (e.g., the wireless communication module 892) may transmit or receive the signal to or from the external electronic device through the antenna suitable for the communication method.

Some components among the components may be connected to each other through a communication method (e.g., a bus, a general purpose input/output (GPIO), a serial peripheral interface (SPI), or an mobile industry processor interface (MIPI)) used between peripheral devices to exchange signals (e.g., a command or data) with each other.

According to an embodiment, the command or data may be transmitted or received between the electronic device 801 and the external electronic device 804 through the server 808 connected to the second network 899. Each of the electronic devices 802 and 804 may be the same or different types as or from the electronic device 801. According to an embodiment, all or some of the operations performed by the electronic device 801 may be performed by another electronic device or a plurality of external electronic devices. When the electronic device 801 performs some functions or services automatically or by request, the electronic device 801 may request the external electronic device to perform at least some of the functions related to the functions or services, in addition to or instead of performing the functions or services by itself. The external electronic device receiving the request may carry out the requested function or the additional function and transmit the result to the electronic device 801. The electronic device 801 may provide the requested functions or services based on the received result as is or after additionally processing the received result. To this end, for example, a cloud computing, distributed computing, or client-server computing technology may be used.

The PCBs 120, 600, and 700 according to various embodiments of the disclosure may be included in the electronic device 801. In this case, the communication module 890 may feed the PCBs 120, 600, and 700 to transmit and receive a signal of a specified frequency band (e.g., 28 GHz).

The electronic device according to various embodiments disclosed in the disclosure may be various types of devices. The electronic device may include, for example, at least one of a portable communication device (e.g., a smartphone), a computer device, a portable multimedia device, a mobile medical appliance, a camera, a wearable device, or a home appliance. The electronic device according to an embodiment of the disclosure should not be limited to the above-mentioned devices.

With regard to description of drawings, similar components may be assigned with similar reference numerals. As used herein, singular forms may include plural forms as well unless the context clearly indicates otherwise. In the disclosure disclosed herein, the expressions "A or B", "at least one of A or/and B", "A, B, or C" or "one or more of A, B, or/and C", and the like used herein may include any and all combinations of one or more of the associated listed items. The expressions "a first", "a second", "the first", or "the second", used in herein, may refer to various components regardless of the order and/or the importance, but do not limit the corresponding components. The above expressions are used merely for the purpose of distinguishing a component from the other components. It should be understood that when a component (e.g., a first component) is referred to as being (operatively or communicatively) "connected," or "coupled," to another component (e.g., a second component), it may be directly connected or coupled directly to the other component or any other component (e.g., a third component) may be interposed between them.

The term "module" used herein may represent, for example, a unit including one or more combinations of hardware, software and firmware. The term "module" may be interchangeably used with the terms "logic", "logical block", "part" and "circuit". The "module" may be a minimum unit of an integrated part or may be a part thereof. The "module" may be a minimum unit for performing one or more functions or a part thereof. For example, the "module" may include an application-specific integrated circuit (ASIC).

Various embodiments of the disclosure may be implemented by software (e.g., the program 840) including an instruction stored in a non-transitory machine-readable storage media (e.g., an internal memory 836 or an external memory 838) readable by a machine (e.g., a computer). The machine may be a device that calls the instruction from the machine-readable storage media and operates depending on the called instruction and may include the electronic device (e.g., the electronic device 801). When the instruction is executed by the processor (e.g., the processor 820), the processor may perform a function corresponding to the instruction directly or using other components under the control of the processor. The instruction may include a code generated or executed by a compiler or an interpreter. The machine-readable storage media may be provided in the form of non-transitory storage media. Here, the term "non-transitory", as used herein, is a limitation of the medium itself (i.e., tangible, not a signal) as opposed to a limitation on data storage persistency.

According to an embodiment, the method according to various embodiments disclosed in the disclosure may be provided as a part of a computer program product. The computer program product may be traded between a seller and a buyer as a product. The computer program product may be distributed in the form of machine-readable storage medium (e.g., a compact disc read only memory (CD-ROM)) or may be distributed only through an application store (e.g., a Play Store^{™}). In the case of online distribution, at least a portion of the computer program product may be temporarily stored or generated in a storage medium such as a memory of a manufacturer's server, an application store's server, or a relay server.

Each component (e.g., the module or the program) according to various embodiments may include at least one of the above components, and a portion of the above sub-components may be omitted, or additional other sub-components may be further included. Alternatively or additionally, some components (e.g., the module or the program) may be integrated in one component and may perform the same or similar functions performed by each corresponding components prior to the integration. Operations performed by a module, a programming, or other components according to various embodiments of the disclosure may be executed sequentially, in parallel, repeatedly, or in a heuristic method. Also, at least some operations may be executed in different sequences, omitted, or other operations may be added.

While the disclosure has been shown and described with reference to various embodiments thereof, it will be understood by those skilled in the art that various changes in form and details may be made therein without departing from the scope of the disclosure as defined by the appended claims.

## Claims

1. An electronic device (100) comprising:
a housing (110) that includes:
a first surface (111),
a second surface (112) facing the first surface, and
a side surface (113) surrounding a space between the first and second surfaces (111, 112);
a printed circuit board, PCB, (120) that is disposed inside the housing and includes at least one antenna unit; and
a communication circuit (130) that is disposed at least one of inside the PCB or between the PCB and the housing,
wherein the PCB includes:
a first substrate (121),
a second substrate (123) facing the first substrate (121), and
a spacer (122) disposed between the first and second substrates (121, 123), the spacer including an opening (122h) extending from the first substrate (121) to the second substrate (123), and wherein a side surface of an inner space of the opening of the spacer (122) is plated or surrounded by a conductive material,
wherein each of the at least one antenna unit (124, 125) includes:
a first conductive member (124-1, 125-1) formed on the first substrate (121),
a second conductive member (124-2, 125-2) formed on the second substrate (123) and facing the first conductive member (124-1, 125-1) through the opening (122h), and
a feeder (124-3, 125-3) connecting the second conductive member (124-2, 125-2) to the communication circuit (130), and
wherein the communication circuit (130) is configured to feed to the feeder (124-3, 125-3) and is configured to at least one of transmit or receive a signal of a specified frequency band through an electrical path formed through the feeder (124-3, 125-3) and the second conductive member (124-2, 125-2).

2. The electronic device of claim 1, wherein a dielectric material is provided in a space between the second conductive member (124-2, 125-2) and the first conductive member (124-1, 125-1).

3. The electronic device of claim 1, wherein each of the at least one antenna unit (124, 125) further includes a plurality of vias (126) surrounding the opening (122h).

4. The electronic device of claim 3,
wherein the at least one antenna unit (124, 125) includes a first antenna unit (124) and a second antenna unit (125), and
wherein the plurality of vias (126) are configured to block interference between the first and second antenna units (124, 125).

5. The electronic device of claim 3, wherein the first and second antenna units (124, 125) are configured to at least one of transmit or receive signals of mutually different frequency bands.

6. The electronic device of claim 1, wherein the first conductive member (124-1, 125-1) and the second conductive member (124-2, 125-2) are formed of a conductive material.

7. The electronic device of claim 1, wherein the first conductive member (124-1, 125-1) is spaced a specified distance from the spacer (122), and the spacer (122) is spaced the specified distance from the second conductive member (124-2, 125-2).

8. The electronic device of claim 1,
wherein the first substrate (121) and the spacer (122) adhere to each other by an adhesive material, and
wherein the spacer (122) and the second substrate (123) adhere to each other by the adhesive material.

9. The electronic device of claim 1,
wherein the spacer (122) includes a plurality of non-conductive layers (122-1, 122-2, 122-3, 122-4), and
wherein conductive layers (122a, 122b, 122c, 122d, 122e) are disposed between the plurality of non-conductive layers (122-1, 122-2, 122-3, 122-4), respectively.

10. The electronic device of claim 1, wherein the PCB is disposed between the second conductive member (124-2, 125-2) and the spacer (122) and further includes a non-conductive material surrounding the second conductive member (124-2, 125-2).

## Patentansprüche

1. Elektronische Vorrichtung (100), umfassend:
ein Gehäuse (110), das Folgendes beinhaltet:
eine erste Oberfläche (111),
eine zweite Oberfläche (112), die der ersten Oberfläche zugewandt ist, und
eine Seitenoberfläche (113), die einen Raum zwischen der ersten und der zweiten Oberfläche (111, 112) umgibt;
eine gedruckte Leiterplatte, PCB, (120), die innerhalb des Gehäuses angeordnet ist und zumindest eine Antenneneinheit beinhaltet; und
eine Kommunikationsschaltung (130), die entweder innerhalb der PCB oder zwischen der PCB und dem Gehäuse angeordnet ist,
wobei die PCB Folgendes beinhaltet:
ein erstes Substrat (121),
ein zweites Substrat (123), das dem ersten Substrat (121) zugewandt ist, und
einen Abstandshalter (122), der zwischen dem ersten und dem zweiten Substrat (121, 123) angeordnet ist, wobei der Abstandshalter eine Öffnung (122h) beinhaltet, die sich von dem ersten Substrat (121) zu dem zweiten Substrat (123) erstreckt, und wobei eine Seitenoberfläche eines Innenraums der Öffnung des Abstandshalters (122) plattiert oder durch ein leitfähiges Material umgeben ist,
wobei jede von der zumindest einen Antenneneinheit (124, 125) Folgendes beinhaltet:
ein erstes leitfähiges Element (124-1, 125-1), das auf dem ersten Substrat (121) gebildet ist,
ein zweites leitfähiges Element (124-2, 125-2), das auf dem zweiten Substrat (123) gebildet und dem ersten leitfähigen Element (124-1, 125-1) durch die Öffnung (122h) zugewandt ist, und
eine Zuleitung (124-3, 125-3), die das zweite leitfähige Element (124-2, 125-2) mit der Kommunikationsschaltung (130) verbindet, und
wobei die Kommunikationsschaltung (130) konfiguriert ist, um der Zuleitung (124-3, 125-3) zuzuleiten, und konfiguriert ist, um ein Signal eines spezifizierten Frequenzbands durch einen elektrischen Pfad, der durch die Zuleitung (124-3, 125-3) und das zweite leitfähige Element (124-2, 125-2) gebildet ist, entweder zu übertragen oder zu empfangen.

2. Elektronische Vorrichtung nach Anspruch 1, wobei ein dielektrisches Material in einem Raum zwischen dem zweiten leitfähigen Element (124-2, 125-2) und dem ersten leitfähigen Element (124-1, 125-1) bereitgestellt ist.

3. Elektronische Vorrichtung nach Anspruch 1, wobei jede von der zumindest einen Antenneneinheit (124, 125) ferner eine Vielzahl von Durchkontaktierungen (126) beinhaltet, welche die Öffnung (122h) umgeben.

4. Elektronische Vorrichtung nach Anspruch 3,
wobei die zumindest eine Antenneneinheit (124, 125) eine erste Antenneneinheit (124) und eine zweite Antenneneinheit (125) beinhaltet, und
wobei die Vielzahl von Durchkontaktierungen (126) konfiguriert ist, um Interferenz zwischen der ersten und der zweiten Antenneneinheit (124, 125) zu blockieren.

5. Elektronische Vorrichtung nach Anspruch 3, wobei die erste und die zweite Antenneneinheit (124, 125) konfiguriert sind, um Signale von gegenseitig unterschiedlichen Frequenzbändern entweder zu übertragen oder zu empfangen.

6. Elektronische Vorrichtung nach Anspruch 1, wobei das erste leitfähige Element (124-1, 125-1) und das zweite leitfähige Element (124-2, 125-2) aus einem leitfähigen Material gebildet sind.

7. Elektronische Vorrichtung nach Anspruch 1, wobei das erste leitfähige Element (124-1, 125-1) einen festgelegten Abstand von dem Abstandshalter (122) beabstandet ist und der Abstandshalter (122) den festgelegten Abstand von dem zweiten leitfähigen Element (124-2, 125-2) beabstandet ist.

8. Elektronische Vorrichtung nach Anspruch 1,
wobei das erste Substrat (121) und der Abstandshalter (122) durch ein Klebematerial aneinander haften, und
wobei der Abstandshalter (122) und das zweite Substrat (123) durch das Klebematerial aneinander haften.

9. Elektronische Vorrichtung nach Anspruch 1,
wobei der Abstandshalter (122) eine Vielzahl von nicht leitfähigen Schichten (122-1, 122-2, 122-3, 122-4) beinhaltet, und
wobei leitfähige Schichten (122a, 122b, 122c, 122d, 122e) jeweils zwischen der Vielzahl von nicht leitfähigen Schichten (122-1, 122-2, 122-3, 122-4) angeordnet sind.

10. Elektronische Vorrichtung nach Anspruch 1, wobei die PCB zwischen dem zweiten leitfähigen Element (124-2, 125-2) und dem Abstandshalter (122) angeordnet ist und ferner ein nicht leitfähiges Material beinhaltet, welches das zweite leitfähige Element (124-2, 125-2) umgibt.

## Revendications

1. Dispositif électronique (100) comprenant :
un boîtier (110) qui comprend :
une première surface (111),
une seconde surface (112) faisant face à la première surface, et
une surface latérale (113) entourant un espace entre les première et seconde surfaces (111, 112) ;
une carte de circuit imprimé, PCB, (120) qui est disposée à l'intérieur du boîtier et comprend au moins une unité d'antenne ; et
un circuit de communication (130) qui est disposé au moins à l'intérieur de la PCB ou entre la PCB et le boîtier, ladite PCB comprenant :
un premier substrat (121),
un second substrat (123) faisant face au premier substrat (121), et
une entretoise (122) disposée entre les premier et second substrats (121, 123), l'entretoise comprenant une ouverture (122h) s'étendant à partir du premier substrat (121) jusqu'au second substrat (123) et une surface latérale d'un espace interne de l'ouverture de l'entretoise (122) étant plaquée ou entourée d'un matériau conducteur,
chacune de l'au moins une unité d'antenne (124, 125) comprenant :
un premier élément conducteur (124-1, 125-1) formé sur le premier substrat (121),
un second élément conducteur (124-2, 125-2) formé sur le second substrat (123) et faisant face au premier élément conducteur (124-1, 125-1) à travers l'ouverture (122h), et
un dispositif d'alimentation (124-3, 125-3) connectant le second élément conducteur (124-2, 125-2) au circuit de communication (130), et
ledit circuit de communication (130) étant conçu pour alimenter le dispositif d'alimentation (124-3, 125-3) et étant conçu pour au moins émettre ou recevoir un signal d'une bande de fréquences spécifiée par un chemin électrique formé par le dispositif d'alimentation (124-3, 125-3) et le second élément conducteur (124-2, 125-2).

2. Dispositif électronique selon la revendication 1, un matériau diélectrique étant prévu dans un espace entre le second élément conducteur (124-2, 125-2) et le premier élément conducteur (124-1, 125-1).

3. Dispositif électronique selon la revendication 1, chacune des au moins une unité d'antenne (124, 125) comprenant en outre une pluralité de vias (126) entourant l'ouverture (122h).

4. Dispositif électronique selon la revendication 3,
ladite au moins une unité d'antenne (124, 125) comprenant une première unité d'antenne (124) et une seconde unité d'antenne (125), et
ladite pluralité de vias (126) étant conçus pour bloquer les interférences entre les première et seconde unités d'antenne (124, 125).

5. Dispositif électronique selon la revendication 3, lesdites première et seconde unités d'antenne (124, 125) étant conçues pour au moins émettre ou recevoir des signaux de bandes de fréquences mutuellement différentes.

6. Dispositif électronique selon la revendication 1, ledit premier élément conducteur (124-1, 125-1) et ledit second élément conducteur (124-2, 125-2) étant formés d'un matériau conducteur.

7. Dispositif électronique selon la revendication 1, ledit premier élément conducteur (124-1, 125-1) étant espacé d'une distance spécifiée de l'entretoise (122), et ladite entretoise (122) étant espacée de la distance spécifiée du second élément conducteur (124-2, 125-2).

8. Dispositif électronique selon la revendication 1,
ledit premier substrat (121) et ladite entretoise (122) adhérant l'un à l'autre au moyen d'un matériau adhésif, et
ladite entretoise (122) et ledit second substrat (123) adhérant l'un à l'autre au moyen du matériau adhésif.

9. Dispositif électronique selon la revendication 1,
ladite entretoise (122) comprenant une pluralité de couches non conductrices (122-1, 122-2, 122-3, 122-4), et
des couches conductrices (122a, 122b, 122c, 122d, 122e) étant disposées entre la pluralité de couches non conductrices (122-1, 122-2, 122-3, 122-4), respectivement.

10. Dispositif électronique selon la revendication 1, ladite PCB étant disposée entre le second élément conducteur (124-2, 125-2) et l'entretoise (122) et comprenant en outre un matériau non conducteur entourant le second élément conducteur (124-2, 125-2).
